# EUROPEAN PATENT APPLICATION

(11) **EP 3 327 881 A1**
(43) Date of publication of application: **30.05.2018**
(21) Application number: 16200581.3
(22) Date of filing: 24.11.2016
(51) Int. Cl.: H01S 5/10, H01S 5/50, H01S 5/16

(54) **RELIABLE OPTOELECTRINIC DEVICES**

(71) Applicant: Alcatel Lucent, 91620 Nozay (FR)
(72) Inventor: MAHO, Anaëlle, 91767 PALAISEAU (FR); BRENOT, Romain, 91767 PALAISEAU (FR); MEKHAZNI, Karim, 91767 PALAISEAU (FR)
(74) Representative: Novagraaf Technologies

(57) **Abstract**

The present invention relates to a method for making a reliable optoelectronic device (10, 20, 30) comprising a laminated structure including a semiconducting active layer (12) containing an oxidizing material such as AlGaInAs, the device presenting a first (14) and a second (15) facets, the method comprises integration of a transition from the oxidizing material to a non-oxidizing semiconducting material (12', 13) between the active layer and at least one of the first and second facets.

## Description

### Field of the Invention

The present invention relates to Semiconductor Optical devices such as Distributed Feedback Lasers (DFB) or Reflective Semiconductor Optical Amplifiers (RSOA). In particular, the invention relates to a method for making reliable reflective facets of such devices.

### Background

Optoelectronic devices such as distributed feedback lasers (DFB) or reflective semiconductor optical amplifiers (RSOA) have to present high energy efficiency, high capacity and a low cost.

The active layer of such devices is commonly made of semiconducting materials containing phosphorus, such as InGaAsP, or of semiconducting material containing aluminium, such as AlGaInAs.

The use of a semiconducting material containing aluminium, allows to improve performances of these devices compared to the phosphorus-based materials. For example, devices containing an active layer of AlGaInAs are faster than those containing InGaAsP, and show less current leakage and high temperature operation.

However, the aluminium oxidizes easily when it is exposed to the air which affects the reliability and the performances of the devices. In particular, most of optoelectronic devices such as RSOA have cleaved facets of the active layer which are directly in contact with the air.

The objective of the present invention is to provide a method for preventing the use of oxidized facets in devices containing an active layer including an oxidizing semiconducting material.

### Summary

In a first general embodiment, the invention relates to a method for making a reliable optoelectronic device comprising a laminated structure including a semiconducting active layer containing an oxidizing material, the device presenting a first facet and a second facet. According to the invention, the method comprises integration of a transition in a non-oxidizing material between the active layer and at least one of the first and second facets.

By the expression "comprises integration of a transition in a non-oxidizing material" we mean that the light pass through said non-oxidizing material to the active layer and/or inversely.

Thanks to the transition to the non-oxidizing semiconducting material, the method according to the invention makes it possible to avoid oxidation at the facets of semiconducting optoelectronic devices. Consequently the facets and the device are reliable.

The oxidizing material is for example AlGaInAs. Other semiconducting materials may be used instead.

Advantageously, the device further comprises a lower layer including the second non-oxidizing material.

The non-oxidizing semiconducting material is, for example, InGaAsP. Other materials such as InGaAs may be also used.

In one embodiment of the invention, at least one of the first and second facets is reflective.

According to an embodiment of the integration of the transition in the non-oxidizing material comprises forming a dual spot size converter including a ridge made in the semiconducting active layer containing the oxidizing material, by using steps of:
- etching the active layer, at the first facet, so as it presents a tapered part, the end of which is at a certain distance from the first facet, and then
- inversely etching the lower layer so as it presents nearly a same width as a non-tapered part of the ridge and a larger width then tapered part of the ridge, said lower layer ends at the first facet.

Forming a dual spot size converter (SSC) is a simple a method for integrating the transition to the non-oxidizing material and thus avoid oxidizing facets.

Further, as the reflective facet is usually cleaved directly into the ridge, this allows a better fiber coupling reflective facet.

According to another embodiment of the invention, integration of the transition in the non-oxidizing material includes forming a dual spot size converter including a ridge made in the semiconducting active layer containing the oxidizing material, by using steps of:
- etching the active layer, at the first facet and the second facet so as it presents a first tapered part, the end of which is at a first distance from the first facet, and a second tapered part, the end of which is at a second distance from the second facet, and then
- inversely etching the lower layer so as it presents nearly a same width as a non-tapered part of the active layer and a larger width then tapered parts of the active layer, the lower layer ends at the first facet and at the second facet.

Thus both facets are non-oxidizing facets, therefore the device is more reliable.

According to a third embodiment, the integration of the transition in the non-oxidizing semiconducting material comprises steps of:
- etching the active layer containing the oxidizing material at the first facet, and then
- growing another active layer including the non-oxidizing material where the active layer including the oxidizing material has been etched.

The invention also relates to an optoelectronic device obtained by the method of the invention as described above.

Said optoelectronic device may be a laser, an RSOAor a modulator.

### Brief Description of the Drawings

Some embodiments of the method in accordance with the present invention are now described, by way of examples only, and with reference to the accompanying drawings, in which :
- The Figures 1A to 2C schematically illustrate an example of RSOA device according the state of the art;
- The Figures 3 and 4 schematically illustrate a first embodiment of the present invention;
- The Figures 5 and 6 schematically illustrate a second general embodiment of the present invention.
- The Figures 7 to 8C schematically illustrate a third general embodiment of the present invention.

### Description of Embodiments

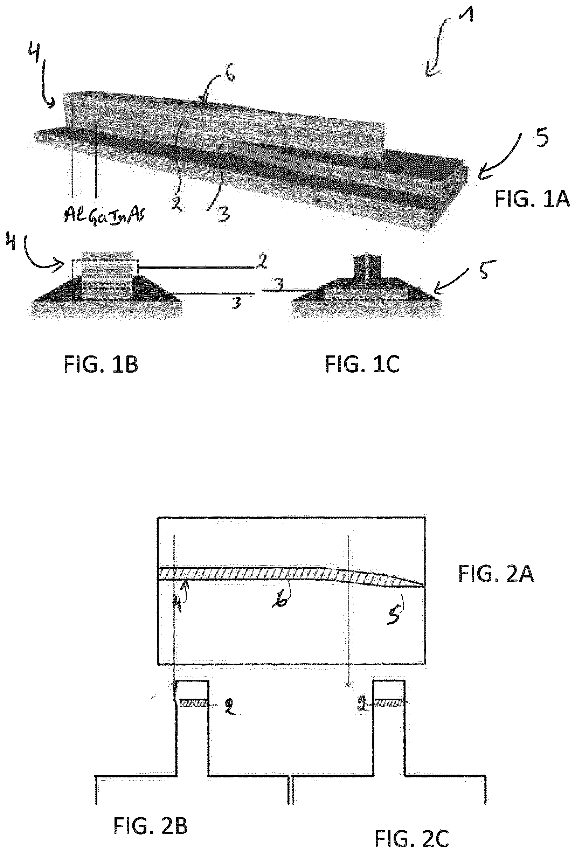

Figure 1A shows an example of RSOA device 1 according to the state of the art.
This device presents a laminated structure including an active layer 2 and a lower layer 3, both containing a semiconducting material containing aluminium, for example AlGaInAs.
The device presents a high reflectivity facet 4, commonly called « mirror » and a low reflectivity facet 5.
In a such device of the stat of the art, the high reflectivity facet 5 and the low reflectivity facet containing aluminium oxidize, inducing a reduction in performance of these facets and consequently reduction in performance of the device.

Figure 1B and Figure 1C show respectively a side view of the reflective facet 4 and a side view of the low reflectivity facet 5.

Figure 2A shows a schematic top view of a standard RSOA similar to the one shown in Figure 1A showing the ridge 6, the reflective facet 4 and the low reflectivity facet 5.

Figure 2B and Figure 2C show respectively a cut view at the reflective facet 4 and a cut view at the ridge 6 as indicated by the rows.

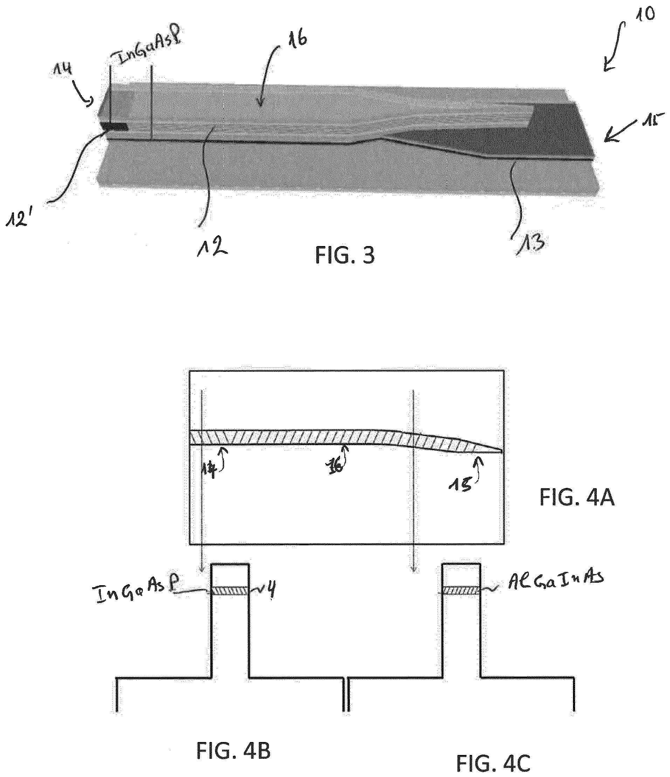

Figure 3 shows an example of RSOA device 10 according to a first embodiment of the invention.

This device presents a generally similar laminated structure including an active layer 12 containing a semiconducting material containing aluminium, AlGaInAs.

In this device the active layer presents at the high reflectivity facet 14, instead of the material containing aluminium, a phosphorus based semiconducting material.

Such transition in phosphorus at the high reflectivity facet may be obtained starting from a standard RSOA as the one illustrated by figures 1A-2C by the steps of:
- etching at the high reflectivity facet 14 , the semiconducting active layer containing aluminium, and then
- growing the phosphorus based material where the active layer has been etched.

Therefore, thanks to this transition the active layer containing aluminium is not exposed to the atmosphere.

As the phosphorus based conducting materials like InGaAsP does not oxidize the obtained high reflectivity facet 14 is more reliable.

Figure 4A shows a schematic top view of a the obtained RSOA to the one shown in Figure 3 showing the ridge 16, the reflective facet 14 and the low reflectivity facet 15.

Figure 4B and Figure 4C show respectively a cut view at the reflective facet 14 and a cut view at the ridge 16 as indicated by the rows.

As can be seen comparing Figures 4A-C to Figures 2A-C, the only deference is the active layer at the high reflectivity facet.

A further difference comparing figure 3 to Figure 1A is in the lower layer 3, 13 wherein the material of this layer is a phosphorus based material, like InGaAsP, instead of the material containing aluminium.

This presents the advantage of getting a non-oxidizing low reflectivity facet.

Further a cleaving is made in the phosphorus based material of both the high and low reflectivity facets 14, 15.

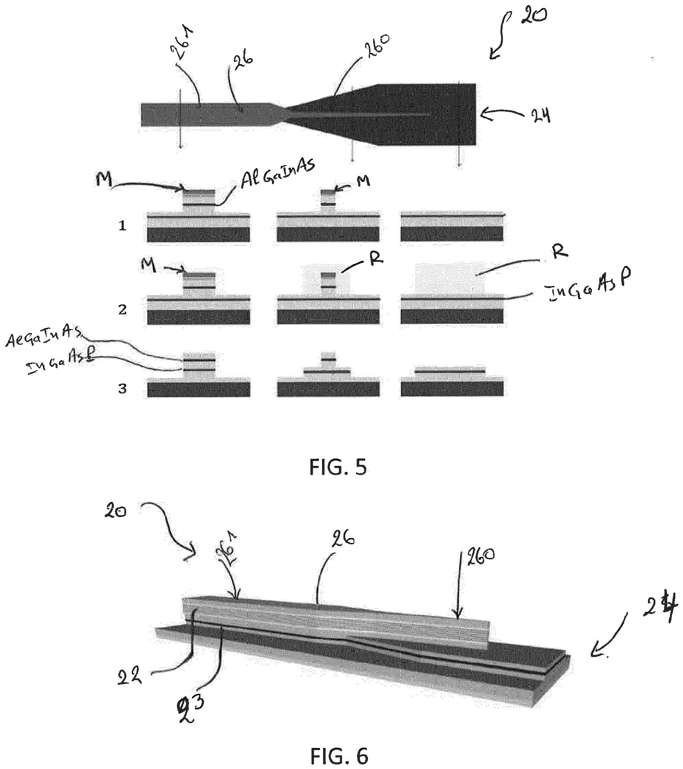

Figures 5 and 6 show an example of steps for realizing a reliable RSOA device 20 the top view of which is shown in top of figure 5, and a side view is shown in figure 6. The method uses the following steps. Here, a spot size converter is realized in one facet only.

First a substrate is provided with a layered structure containing an active layer including AlGaInAs and lower layer containing InGaAsP, this substrate presents a first facet which highly reflective 24 and a second facet 25 with a low reflectivity.

Then:
- **In step 1:** a physical mask M including a taper shape is placed on the substrate; then the active layer is etched so as to form a ridge 26 including a taper 260 the end of which is situated at a certain distance from the reflective facet, typically 20 µm or more. The taper is typically in the range of 100-200 µm.
- **Step 2:** while the mask M is still in place, a resist R is deposited by photolithography which covers partially the lower layers (under the active layer) and the taper 260, but not the non-tapered part of the ridge 26, which is only covered by the mask M. The resist R ends at the reflective facet 24.
- **Step 3:** the lower layer is etched so as it has nearly the same width as the active layer under the non-tapered part 261 of the ridge 26 and a larger width under the tapered part 260 of the ridge 26. Said lower layer end at the reflective facet 24.

In another embodiment, at the step 2, instead of using the resist we may use a second mask.

At the end the resist R and mask M, are removed by conventional methods.

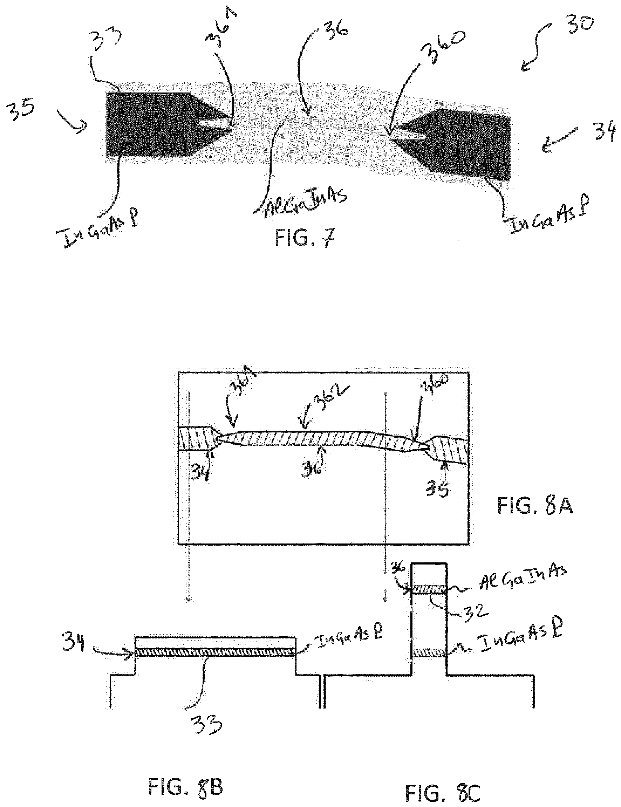

Figures 7 and 8A-C show an example of a reliable RSOA device 30 the top view of which is shown in figures 7 and 8A, and a cut views are shown in figures 8B, 8C, the cut being realised in the areas indicated by the descending arrows.

Here, a dual spot seize converter is realized in both the reflective 34 and the low reflectivity 35 facets. The method uses the following steps.

First a substrate is provided with a layered structure containing an active layer including AlGaInAs and lower layer containing InGaAsP, this the active layer presents a first facet 24 which highly reflective and a second facet with a low reflectivity 35.

Then:
- **In step 1:** a physical mask M including a taper shape in both sides, toward the first and second facets, is placed on the substrate; then the active layer is etched so as to form a ridge 36 including a two tapers 360, 361 the ends of which are situated at a certain distance from the respective facets, typically 20 µm or more. The tapers are typically in the range of 100-200 µm.
- **Step 2:** while the mask is still in place, a resist is deposited by photolithography which covers partially the lower layer and the tapers 360, 361 but not the non-tapered part of the ridge 36 which is only covered by the mask. The resist R ends at the first and second facets 34, 35.
- **Step 3:** the lower layer is etched so as it has nearly the same width as the active layer under the non-tapered part 362 of the ridge 36 and a larger width under the tapered parts 360, 361 of the ridge 36. Said lower layer ends at both facets 34,35.

In another embodiment, at the step 2, instead of using the resist we may use a second mask.

At the end the resist R and mask M, are removed by conventional methods.

Further a cleaving is made in the phosphorus based material of both the high and low reflectivity facets 14, 15.

In this description we assume that it is known to those skilled in the art that all the mentioned layers may be obtained by conventional growth methods such as epitaxy growth.

In practice, a wafer contains a plurality of devices being fabricated at the same time, therefore, by facets we mean the facets obtained after separation of the devices by cleaving.

The methods described in this patent application may also be implemented to other semiconducting optoelectronic devices such as Lasers, or modulator.

The description and drawings merely illustrate the principles of the invention. It will thus be appreciated that those skilled in the art will be able to devise various arrangements that, although not explicitly described or shown herein, embody the principles of the invention and are included within its spirit and scope.

For example InGaAsP, or may be replaced by another non-oxidizing semiconducting such as InGaAs and AlGaInAs may be replaced by another oxidizing semiconducting material.

Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A method for making a reliable optoelectronic device (1; 10; 20; 30) comprising a laminated structure including a semiconducting active layer (2; 12; 22) containing an oxidizing material, the device presenting a first facet (4; 14; 24; 34) and a second facet (5; 15; 25; 35), the method being **characterised in that** it comprises integration of a transition in a non-oxidizing semiconducting material between the active layer and at least one of the first (4; 14; 24; 34) and second (5; 15; 25; 35) facets.

2. The method according to claim 1, wherein the oxidizing material is AlGaInAs.

3. The method according to anyone of claims 1 and 2, wherein the device further comprises a lower layer (3; 13; 23; 33), including the second non-oxidizing material.

4. The method according to any of claims 1 to 3, wherein at least one of the first and second non-oxidizing materials is InGaAsP.

5. The method according to anyone of claims 1 to 4, wherein at least one of the first and second facet is reflective.

6. The method according to anyone of claims 1 to 5, wherein the integration of the transition in the non-oxidizing semiconducting material comprises forming a dual spot size converter including a ridge (26) made in the semiconducting active layer (22) containing the oxidizing material, by using steps of:
- etching the active layer (22), at the first facet (24), so as it presents a tapered part (260), the end of which is at a certain distance from the first facet, and then
- inversely etching the lower layer (23) so as it presents nearly a same width as a non-tapered part (261) of the ridge and a larger width then tapered part (260) of the ridge, said lower layer (23) ends at the first facet (24).

7. The method according to anyone of claims 1-5, wherein the integration of the transition in the non-oxidizing material includes forming a dual spot size converter including a ridge (36) made in the semiconducting active layer (33) containing the oxidizing material, by using steps of:
- etching the active layer (32), at the first facet (34) and the second facet (35) so as it presents a first tapered part (360), the end of which is at a first distance from the first facet (34), and a second tapered part (261), the end of which is at a second distance from the second facet (35), and then
- inversely etching the lower layer (33) so as it presents nearly a same width as a non-tapered part of the active layer (32) and a larger width then tapered parts (260, 261) of the active layer (32), the lower layer (33) ends at the first facet (34) and at the second facet (35).

8. The method according to anyone of claims 1 and 5, wherein the integration of the transition in the non-oxidizing semiconducting material comprises steps of:
- etching the active layer (12) containing the oxidizing material at the first facet (14), and then
- growing another active layer (12') including the non-oxidizing material where the active layer (12) including the oxidizing material has been etched.

9. An optoelectronic device including obtained by the method according to anyone of claims 1 to 8.

10. The optoelectronic device according to claim 9, wherein said optoelectronic device is a Laser or an RSOA.
